# EUROPÄISCHE PATENTSCHRIFT

(11) **EP 2 745 179 B1**
(45) Veröffentlichungstag und Bekanntmachung des Hinweises auf die Patenterteilung: **04.10.2017**
(21) Anmeldenummer: 12750746.5
(22) Anmeldetag: 17.08.2012
(51) Int. Cl.: G05B 19/042, G05B 19/05, H01T 4/06

(54) **BASISELEMENT ZUR AUFNAHME EINES ÜBERSPANNUNGSSCHUTZMODULS UND MODULARES BUSSYSTEM**
BASE ELEMENT FOR ACCOMMODATING AN OVERVOLTAGE PROTECTION MODULE, AND MODULAR BUS SYSTEM
ÉLÉMENT DE BASE POUR SUPPORTER UN MODULE DE PROTECTION CONTRE LES SURTENSIONS ET SYSTÈME DE BUS MODULAIRE

(30) Priorität: 18.08.2011 DE 102011052803; 08.03.2012 DE 202012002282 U
(43) Veröffentlichungstag der Anmeldung: 25.06.2014
(73) Patentinhaber: Phoenix Contact GmbH & Co. KG, 32825 Blomberg (DE)
(72) Erfinder: PFÖRTNER, Steffen, 31832 Springe (DE); SIEGEL, Andrei, 33100 Paderborn (DE); MEYER, Thomas, 31868 Ottenstein (DE)
(74) Vertreter: Michalski Hüttermann & Partner Patentanwälte mbB
(86) Internationale Anmeldenummer: PCT/EP2012/066079
(87) Internationale Veröffentlichungsnummer: WO 2013/024151

(56) Entgegenhaltungen:
- DE-A1-102006 038 005
- DE-A1-102008 063 816
- DE-A1-102009 015 068
- US-A- 6 000 825

## Beschreibung

Die Erfindung betrifft ein Basiselement zur Aufnahme eines Überspannungsschutzmoduls als auch ein modulares Bussystem mit einem oder mehreren Basiselementen der vorgenannten Art.

In vielen Bereichen werden heutzutage eine Vielzahl von Überspannungsschutzgeräten installiert. Dabei nimmt mit zunehmender Komplexität von Anlagen und Geräten auch das Risiko zu, dass ein fehlerhaft eingebautes Überspannungsschutzgerät zu einem Ausfall eines Gerätes oder gar zum Stillstand einer ganzen Anlage führen kann, da der Überspannungsschutz nicht gewährleistet ist.

Um die Komplexität zu minimieren und um die Wartungsfreundlichkeit von Überspannungsschutzgeräten zu erhöhen, wurden steckbare Überspannungsschutzmodule entwickelt.

Allerdings besteht nun das Problem zu erkennen, ob ein Überspannungsschutzmodul korrekt in einer entsprechenden Aufnahme eingesetzt ist, mit anderen Worten, ob das Überspannungsschutzmodul seine Aufgabe auch erfüllen kann. In anderen Technikbereichen, z.B. im Netzschlussbereich, wurden Systeme vorgeschlagen, bei denen ein mechanischer Tastschalter, der in ein Basiselement eingebaut ist, verwendet wird, um eine Aussage über den Steckzustand zu treffen, wie z.B. in der DE 10 2006 038 005 A1. Ein solches System ist beispielsweise in Produkten der Produktserie VAL-MS oder VAL-CP der Anmelderin verkörpert.

Mit zunehmender Miniaturisierung stößt dieses Prinzip jedoch an Grenzen, da die Größe der Bauteile nicht beliebig verkleinert werden kann. Zum anderen sind bei kleineren Bauformen erhöhte Anforderungen an die Fertigungstoleranzen zu stellen. Zudem nimmt die Empfindlichkeit gegenüber Schmutzablagerungen und andere mechanische Einwirkungen, wie Vibrationen oder Stoßbelastungen, stark zu. Weiterhin kann bei häufiger Betätigung der Schalter, also bei häufigem Wechsel der steckbaren Module, auch ein Verschleiß festzustellen sein, der die Schaltsicherheit minimiert. Insofern sind solche Vorrichtungen nur mit erhöhtem Design-und Kostenaufwand in kleinen Baugrößen realisierbar.

Der Erfindung liegt die Aufgabe zu Grunde, ein modulares System für Überspannungsschutzgeräte zur Verfügung zu stellen, welches eine sichere Erkennung auch bei kleinsten Bauformen erlaubt und / oder das zudem kostengünstig herstellbar ist und / oder weiterhin auch den Verdrahtungsaufwand minimiert und zudem die Fehlersicherheit zu erhöhen.

Die Lösung der Aufgabe erfolgt erfindungsgemäß durch die Merkmale des unabhängigen Anspruchs. Vorteilhafte Ausgestaltungen der Erfindung sind in den Unteransprüchen und der Beschreibung angegeben.

Nachfolgend wird die Erfindung unter Bezugnahme auf die anliegende Zeichnung anhand bevorzugter Ausführungsformen näher erläutert.

Es zeigen
- Fig. 1: eine schematische Darstellung eines modularen Bussystems gemäß einer bevorzugten Ausführungsform der Erfindung,
- Fig. 2: eine schematische Darstellung eines Basiselementes mit einem zu steckenden Überspannungsschutzmodul gemäß einer bevorzugten Ausführungsform der Erfindung,
- Fig. 3: eine schematische Darstellung einer ersten Ausführungsform einer Überwachungseinrichtung in einem Basiselement gemäß einer bevorzugten Ausführungsform der Erfindung,
- Fig. 4: eine schematische Darstellung einer zweiten Ausführungsform einer Überwachungseinrichtung in einem Basiselement gemäß einer bevorzugten Ausführungsform der Erfindung,
- Fig. 5: eine schematische Darstellung von Elementen eines Basiselementes gemäß einer bevorzugten Ausführungsform der Erfindung,
- Fig. 6: eine schematische Darstellung von Elementen eines Kopfmoduls gemäß einer bevorzugten Ausführungsform der Erfindung,
- Fig. 7: eine schematische Schnittdarstellung eines Busmoduls und einer Tragschiene zur Verwendung in einer bevorzugten Ausführungsform der Erfindung,
- Fig. 8: eine schematische Perspektivdarstellung von Busmodulen und einer Tragschiene zur Verwendung in einer bevorzugten Ausführungsform der Erfindung,
- Fig. 9: eine schematische Schnittdarstellung eines Busmoduls und einer Tragschiene in Verwendung mit einem Überspannungsschutzmodul und einem Basiselement gemäß einer bevorzugten Ausführungsform der Erfindung,
- Fig. 10: eine schematische Darstellung verschiedener Busverlängerungen über Tragschienen hinweg gemäß einer bevorzugten Ausführungsform der Erfindung, und
- Fig. 11: eine schematische Darstellung einer Ausgestaltung mit zwei Kopfmodulen gemäß einer bevorzugten Ausführungsform der Erfindung.

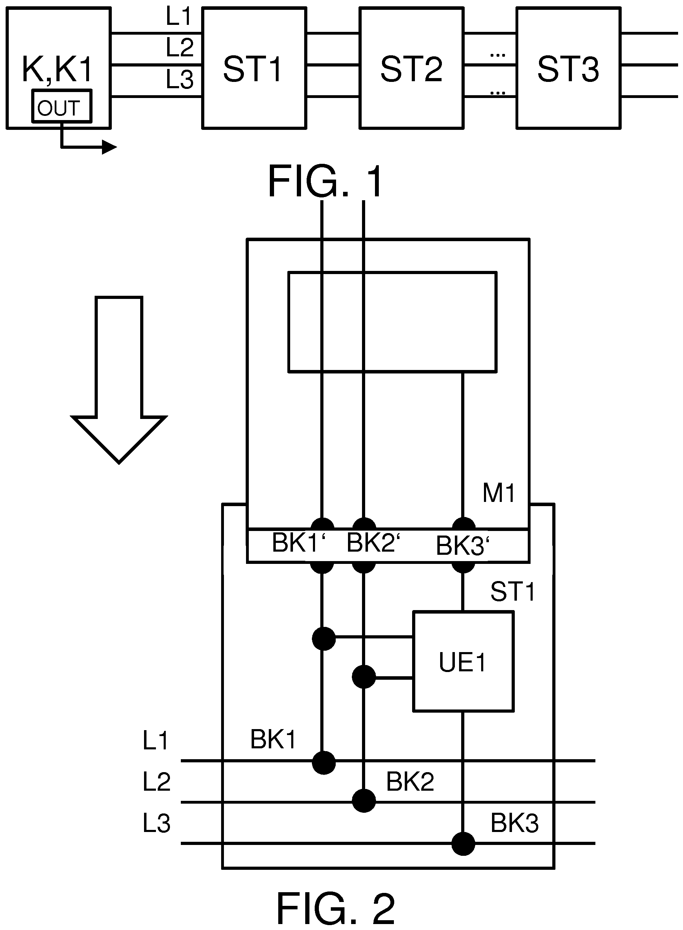

Figur 1 zeigt eine schematische Darstellung eines modularen Bussystems gemäß einer bevorzugten Ausführungsform der Erfindung. Das Bussystem weist ein Kopfmodul K1 und ein oder mehrere Basiselemente ST1, ST2, ST3 auf. Das Kopfmodul K1 und das Basiselement oder die Basiselemente ST1, ST2, ST3 sind über ein Bussystem verbunden, welches im dargestellten Beispiel zumindest 3 logische Leitungen aufweist.

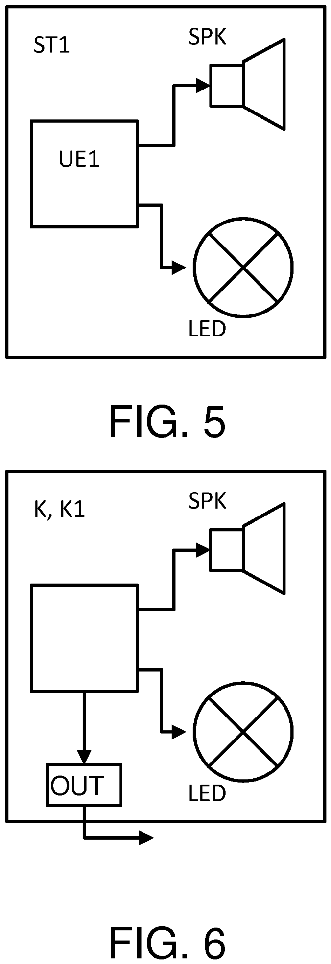

Jedes der Basiselemente ST1, ST2, ST3 ist zur Aufnahme eines Überspannungsschutzmoduls M1, M2, M3 geeignet. Das Kopfmodul K1 weist eine erste Busverbindungseinrichtung zur Kontaktierung mit einem ersten Buspotential L1, eine zweite Busverbindungseinrichtung zur Kontaktierung mit einem zweiten Buspotential L2 und eine dritte Busverbindungseinrichtung zur Kontaktierung mit einem Signalbus L3 auf, wobei der Signalbus in einem ersten Zustand das Auftreten eines Fehlers und in einem zweiten Zustand das Nichtauftreten eines Fehlers anzeigt. Weiterhin verfügt das Kopfmodul K1, wie in Figur 6 gezeigt, über zumindest eine Signalisierungseinrichtung, welche anzeigt, ob auf dem Signalbus L3 ein oder mehrere Fehler signalisiert wurde. Eine geeignete Signalisierungseinrichtung kann beispielsweise eine Leuchtanzeige LED, ein Display, oder eine Tongeber SPK oder dergleichen sein. Alternativ oder zusätzlich kann das Kopfmodul K1 auch eine Fernmeldungseinrichtung OUT aufweisen, welche einen erkannten Fehler weitermelden kann. Eine solche Fernmeldeeinrichtung kann beispielsweise ein Feldbussystem oder eine andere geeignete Schnittstelle, wie z.B. USB, Ethernet, usw. sein und in entsprechender Weise ist das Kopfmodul eingerichtet, um für die jeweilige Schnittstelle angepasst Nachrichten über den Zustand bereitzustellen. Weiterhin kann das Kopfmodul K1 auch eine elektronische Verarbeitungseinrichtung zum Auswerten von z.B. 30 oder mehr Daten der Überspannungsschutzmodule bzw. zur Erstellung von Nachrichten zum Versand über die Fernmeldungseinrichtung OUT oder zur Anzeige in einem Display enthalten. Z.B. kann hierfür ein Mikrokontroller oder ein Mikroprozessor vorgesehen sein.

Obwohl andere Anschlusstechniken und Signalisierungen bei der vorgestellten Erfindung möglich wären, wie z.B. der Einsatz von anderen Datenbussystemen, z.B. einem 1-Wire-Bus, ist eine besonders günstige Variante im Folgenden beschrieben. Bei dieser Variante sind den drei logischen Leitungen des Bussystems physikalische Eigenschaften zugeordnet. So ist z.B. vorgesehen, dass über die erste und zweite Busverbindungseinrichtung ein erstes und ein zweites Buspotential seitens des Kopfmoduls K zur Versorgung der Basiselemente ST1, ST2, ST3 und diesen zugeordneten Überspannungsschutzmodulen M1, M2, M3 und der diesen Überspannungsschutzmodulen zugeordneten Geräte oder Anlagen zur Verfügung stellt. Die dritte Leitung, der Signalbus L3, wird zur Signalsierung z.B. von Fehlern der Überspannungsschutzmodule oder fehlerhaft eingeführter Überspannungsschutzmodule verwendet. Z.B. ist dem ersten Buspotential 0 V oder -12 V oder ein Low-Level und dem zweiten Buspotential 3,3 V oder 5 V oder 12 V oder ein High-Level zugeordnet.

Figur 2 zeigt eine schematische Darstellung eines Basiselementes ST1 mit einem zu steckenden Überspannungsschutzmodul M1 gemäß einer bevorzugten Ausführungsform der Erfindung. Dabei wird die Einführrichtung durch den Pfeil angegeben. Das Basiselement ST1, ST2, ST3 weist hierzu mechanische Vorkehrungen auf, die ein sicheres Einführen und eine sichere Halterung des Überspannungsschutzmoduls M1, M2, M3 ermöglicht und den Kontakt mittels der Busverbindungseinrichtungen BK1', BK2', BK3' ermöglichen. Dieses Basiselement weist eine erste Busverbindungseinrichtung BK1 zur Kontaktierung mit dem ersten Buspotential L1, eine zweite Busverbindungseinrichtung BK2 zur Kontaktierung mit dem zweiten Buspotential L2 und eine dritte Busverbindungseinrichtung BK3 zur Kontaktierung mit dem Signalbus L3 auf. Der Signalbus zeigt in einem ersten Zustand das Auftreten eines Fehlers und in einem zweiten Zustand das Nichtauftreten eines Fehlers an, wobei ein Fehler ein fehlendes bzw. fehlerhaft aufgenommenes Überspannungsschutzmodul dem Kopfmodul K oder den Kopfmodulen K, K1 und anderen am Bus angeschlossenen Einrichtungen anzeigt. Dabei soll das erste und zweite Buspotential zur Versorgung von Einrichtungen auf dem Überspannungsschutzmodul M1 verwendet werden. Weiterhin weist das Basiselement eine elektronische Überwachungseinrichtung UE1 auf, wobei die elektronische Überwachungseinrichtung UE1 erkennt, ob ein Überspannungsschutzmodul M1 aufgenommenen ist. Im Falle, dass ein Überspannungsschutzmodul M1 in das Basiselement ST1 aufgenommenen ist, wird der zweite Zustand über den Signalbus signalisiert, und im Falle, dass kein Überspannungsschutzmodul M1 in das Basiselement ST1 aufgenommenen ist oder aber das Überspannungsschutzmodul M1 fehlerhaft aufgenommenen ist, wird der Zustand des Signalbusses nicht verändert.

Im Unterschied zum Stand der Technik erlaubt eine elektronische Überwachungseinrichtung deutlich kleinere Bauformen. Zudem sind elektronische Überwachungseinrichtungen kostengünstig herstellbar und im Gegensatz zu mechanischen Schaltern weniger störanfällig.

In einer vorteilhaften Weiterbildung der Erfindung weist die elektronische Überwachungseinrichtung UE1 einen Halbleiterschalter auf. Halbleiterschalter können besonders kostengünstig hergestellt und integriert werden.

In einer weiteren, vorteilhaften Weiterbildung der Erfindung ist die elektronische Überwachungseinrichtung als ein Öffner geschaltet, wobei im Falle eines korrekt aufgenommen Überspannungsschutzmodul M1 der "Schalter" geöffnet wird.

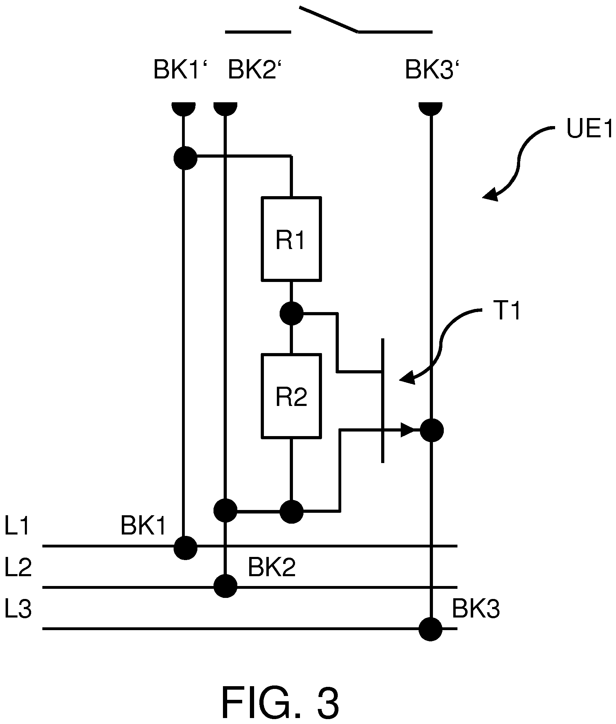

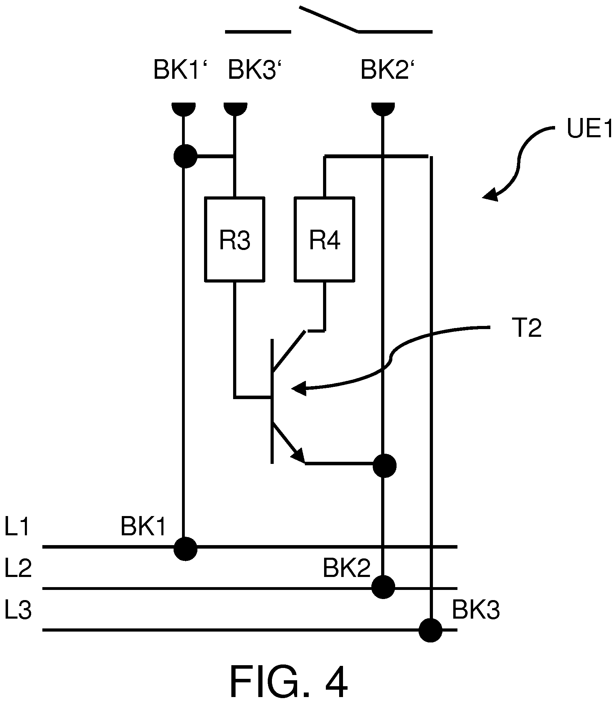

In einer weiteren, vorteilhaften Weiterbildung der Erfindung weist die elektronische Überwachungseinrichtung UE1 einen Transistor T1, T2 auf. Solche Ausführungsformen und schematische Beschaltungen sind in den Figuren 3 und 4 dargestellt. Dabei ist in Figur 3 ein Basiselement ST1 gezeigt, welches mittels der Busverbindungseinrichtungen BK1, BK2 mit dem ersten und zweiten Buspotential L1, L2 verbunden ist. Diese Buspotentiale sind zu Anschlüssen BK1', BK2' zur Verbindung mit einem Überspannungsschutzmodul M1 geführt. Weiterhin ist das Basiselement ST1 mit dem Signalbus L3 mittels der Busverbindungseinrichtung BK3 verbunden, die ebenfalls mit einem Anschluss BK3' zur Verbindung mit dem Überspannungsschutzmodul M1 geführt ist. Zwischen den Buspotentialen ist ein geeignet dimensionierter Spannungsteiler gebildet aus den Widerständen R1 und R2 aufgebaut. Im dargestellten Beispiel ist das erste Buspotential 0 V während das zweite Buspotential 5 V beträgt. Der Spannungsteiler würde dann z.B. mit dem Drain-Anschluss eines p-Kanal (J)FET verbunden werden, während der Source-Anschluss mit dem ersten Buspotential verbunden würde. Ist kein Überspannungsschutzmodul M1 eingeführt, d.h. sind die Kontakte BK1', BK2' und BK3' nicht kontaktiert, so ist der Transistor T1 leitend. Wird ein Überspannungsschutzmodul M1 eingeführt, so signalisiert dieses Überspannungsschutzmodul M1, dass es korrekt funktioniert, in dem es auf den Signalbus L3 über den Kontakt BK3' eine Spannung bzw. einen Strom zur Verfügung stellt, z.B. in dem eine leitende Verbindung, dargestellt als Schließer über den Kontakten BK2' und BK3', herstellt.

Die Ausführungsform gemäß Figur 4 unterscheidet sich nur unwesentlich von der Ausführungsform in Figur 3. Nun wird anstatt eines FET-Transistors ein Bipolartransistor verwendet. Wiederum wird angenommen, dass auf Leitung L1 ein Potential von 0 V und auf Leitung L2 ein Potential von 5 V zur Verfügung gestellt wird. Ein Widerstand R3 ist mit der Basis des npn-Transistors T2 verbunden. Der Emitter ist mit dem zweiten Buspotential verbunden. Der Kollektor wiederum ist mit dem Signalbus L3 verbunden. Im Unterschied zu Figur 3 ist der Signalbus L3 über BK3 nicht zu Anschluss BK3' durchgeschleift. Wird ein Überspannungsschutzmodul M1 eingeführt, so signalisiert dieses Überspannungsschutzmodul M1, dass es korrekt funktioniert, in dem es auf den Signalbus L3 über den Kontakt BK3' eine Spannung bzw. einen Strom zur Verfügung stellt, z.B. in dem eine leitende Verbindung, dargestellt als Schließer über den Kontakten BK2' und BK3', herstellt.

Natürlich können auch andere Halbleiterelemente und Schaltungen verwendet werden. Wesentlich an den Schaltungen für UE1 ist, dass ein fehlerhafter Überspannungsschutz eines einzelnen Moduls zu einer Fehlermeldung im Kopfmodul führt.

Weiterhin kann in vorteilhaften Weiterbildungen der Erfindung, wie in Figur 5 gezeigt, das Basiselement ST1, ST2, ST3 eine lokale Signalisierungseinrichtung zur optischen Anzeige LED und / oder zur akustischen Anzeige SPK aufweisen, um anzuzeigen, ob ein Überspannungsschutzmodul M1, M2, M3 aufgenommen ist. Dabei kann alternativ oder zusätzlich auch eine mechanische Anzeige, welche z.B. einen Farbwechsel bereitstellt, vorgesehen sein, um anzuzeigen, ob das Basiselement ST1 ein korrekt aufgenommenes Überspannungsschutzmodul enthält.

Durch die zuvor beschriebene Ausgestaltung mit einer Öffnerfunktion wird das fehlerhafte Aufnehmen eines einzelnen Überspannungsschutzmoduls auf dem Signalbus nicht durch weitere korrekt aufgenommene Überspannungsschutzmodule gestört. Somit wird im logischen Sinne eine Oder-Funktion realisiert und der Kopfstation der Fehler eines oder mehrerer Überspannungsschutzmodule auf dem von ihm überwachten Bus mitgeteilt.

Befinden sich alle Überspannungsschutzmodule in den jeweiligen Aufnahmen, kann der Signalbus auch für weitere Signalisierungen verwendet werden. So ist es z.B. möglich Daten von einzelnen Überspannungsschutzmodulen M1, M2, M3 abzurufen und den Signalbus L3 für die Datenübertragung von und zum Kopfmodul K, K1 zu verwenden. So ist es z.B. möglich den Zustand der einzelnen Überspannungsschutzmodule M1, M2, M3 zu überwachen. Diese Daten können z.B. vom Kopfmodul K, K1 über eine Fernmeldeeinrichtung OUT weitergeleitet werden.

Weiterhin ist es möglich, dass ein Fehler des Überspannungsschutzmoduls M1, M2, M3 auch mittelbar über das Basiselement erfolgt, z.B. in dem die zuvor beschriebene Schließerfunktion aufgehoben wird und somit faktisch der gleiche Fehler wie ein nicht gestecktes Überspannungsschutzmodul signalisiert wird.

Die vorgestellte Erfindung erlaubt es in besonders kostengünstiger Weise ein busorientiertes Überwachungssystem für Überspannungsschutzmodule bereitzustellen, welches lediglich geringen Bauraum erfordert, kaum Anforderungen an mechanische Toleranzen stellt, unkritisch gegenüber äußeren Störeinflüssen wie Stoß, Vibration, Ablagerungen, Oxidation ist und zudem auch in der Lage ist weitere Daten zu transportieren.

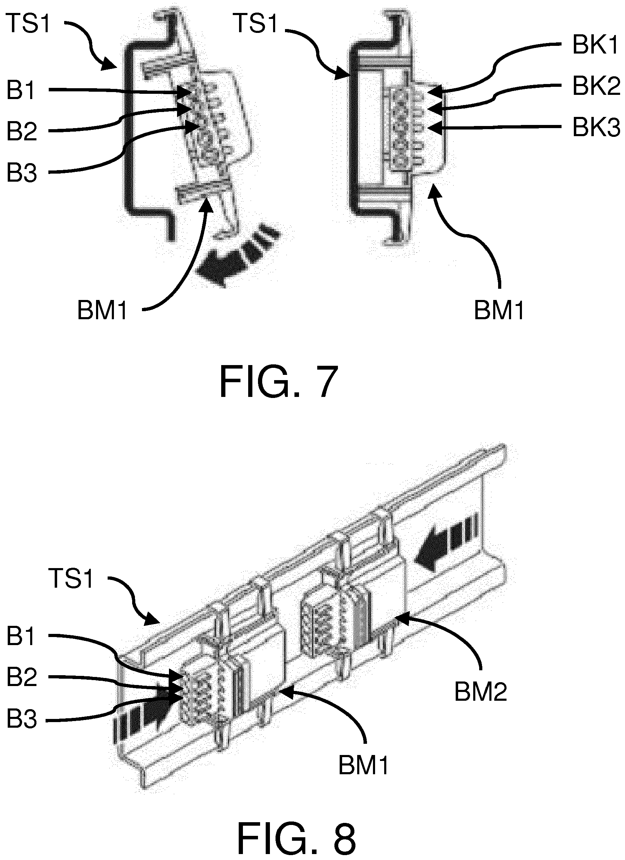

In Figur 7 ist eine schematische Schnittdarstellung eines Busmoduls und einer Tragschiene zur Verwendung in einer bevorzugten Ausführungsform der Erfindung gezeigt.

Dabei wird auf eine Tragschiene TS ein erstes Busmodul BM1 aufgebracht, z.B. - wie im Ablauf der Figur 7 dargestellt - aufgerastet.

Das Busmodul BM1 ist dabei so gestaltet, dass das erste Buspotential L1, das zweite Buspotential L2 und der Signalbus L3 und / oder weitere Signale umrahmt von der Vertiefung der Tragschiene TS geführt werden können. Durch die modulare Gestaltung kann zum einen erreicht werden, dass die Fertigungskosten gering sind, zum anderen kann der Verdrahtungsaufwand minimiert werden, da nun lediglich die Busmodule BM1, BM2 aufzusetzen sind. Somit kann insbesondere für eine Mehrzahl Überspannungsschutzeinrichtungen eine Fernabfrage kostengünstig realisiert werden. Die elektronischen Überwachungseinrichtungen UE1 können über das erste und das zweite Buspotential L1, L2 mit einer Energieversorgung verbunden werden. Über den Signalbus L3 können die Überwachungseinrichtungen UE1 einen Fehler wie zuvor beschrieben einfach signalisieren. Der Verdrahtungsaufwand ist gering, da die Buspotentiale L1, L2 und der Signalbus L3 umrahmt von der Vertiefung der Tragschiene TS geführt werden, wodurch die Verbindung leicht herstellbar ist. Gleichzeitig wird die Fehlersicherheit erhöht, da die Verdrahtung immer auch eine Fehlerquelle darstellt.

Die Busmodule BM1, BM2 sind dabei so gestaltet, dass sie den Kontakt des ersten Buspotentials L1, des zweiten Buspotentials L2 und des Signalbusses L3 zu den Basiselementen ST1, ST2, ST3 über die erste Busverbindungseinrichtung BK1 zur Kontaktierung mit dem ersten Buspotential L1, die zweite Busverbindungseinrichtung BK2 zur Kontaktierung mit dem zweiten Buspotential L2, und die dritte Busverbindungseinrichtung BK3 zur Kontaktierung mit dem Signalbus L3 zur Verfügung stellen.

Dazu weist ein Busmodul BM1, BM2 Busverbindungseinrichtungen BK1, BK2, BK3 auf, die so gestaltet sind, dass sie die jeweiligen Buspotentiale L1, L2, L3 einem aufgesteckten Kopfmodul K, K1 oder einen aufgesteckten Basiselement ST1, ST2, ST3 zur Verfügung stellen können.

Bevorzugt sind die Busmodule BM1, BM2 Bestandteile eines Systembusses.

Weiterhin kann auch das Kopfmodul K, K1 so gestaltet sein, dass es auf eine Tragschiene TS aufrastbar ist.

Das Kopfmodul K, K1 ist dabei so gestaltet, dass es den Kontakt des ersten Buspotentials L1, des zweiten Buspotentials L2 und des Signalbusses L3 zu den Basiselementen ST1, ST2, ST3 über eine erste Busverbindungseinrichtung BK1 zur Kontaktierung mit dem ersten Buspotential L1, eine zweite Busverbindungseinrichtung BK2 zur Kontaktierung mit dem zweiten Buspotential L2, und eine dritte Busverbindungseinrichtung BK3 zur Kontaktierung mit dem Signalbus L3 zur Verfügung stellt.

Weiterhin ist das Busmodul so gestaltet, dass es dennoch eine rastende Aufbringung eines Kopfmoduls K als auch eine rastende Aufbringung eines Basiselementes ST1, ST2, ST3 auf die Tragschiene TS erlaubt.

Ein Busmodul BM1 weist wie in Figur 7 und Figur 8 dargestellt zumindest auf einer Seite in der Ebene der Tragschiene TS Kontakte B1, B2, B3 zur Kontaktierung der Buspotentiale eines benachbarten Busmoduls BM2 auf. Besonders vorteilhaft ist es, wenn die Busmodule BM1, BM2 auf der einen Seite in der Ebene der Tragschiene TS buchsenartige Aufnahmen B1, B2, B3 aufweist, welche mit stiftartigen Aufnahmen eines zweiten Busmoduls BM2 in Verbindung gebracht werden können.

Offensichtlich kann durch dieses Stecker-Steckdosensystem ein kostengünstiger, einfach zu montierender Systembus zur Verfügung gestellt werden.

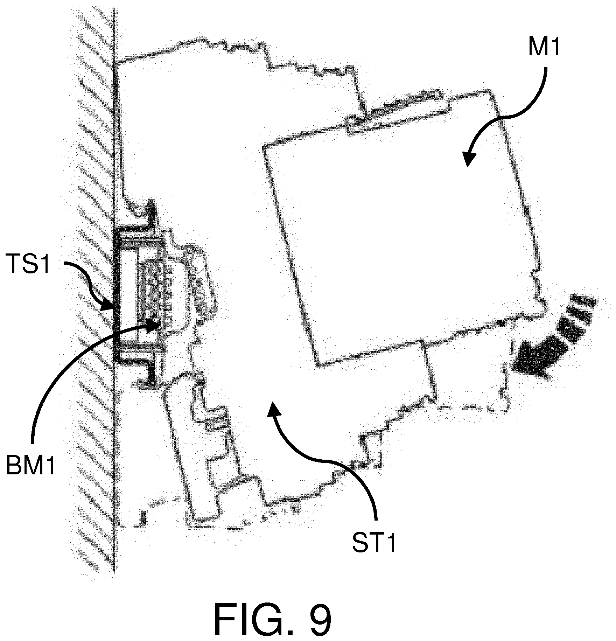

Bei der Montage wird zunächst wie in Figur 7 dargestellt ein Busmodul BM1 auf eine Tragschiene TS1, TS2 aufgerastet. Anschließend kann in gleicher Weise benachbart hierzu ein weiteres Busmodul BM2 aufgebracht werden. Diese können dann wie in Figur 8 dargestellt durch zusammenschieben auf der Tragschiene TS1, TS2 in Kontakt zueinander gebracht werden, wodurch der Bus zur Verfügung gestellt wird. Auf ein Busmodul BM1 kann wie in Figur 9 dargestellt eine Basiselement ST1 aufgebracht werden, in dem wiederum ein Überspannungsschutzmodul M1 aufgenommen werden kann. Alternativ zum Basiselement ST1 kann auch ein Kopfmodul K, K1 aufgebracht werden.

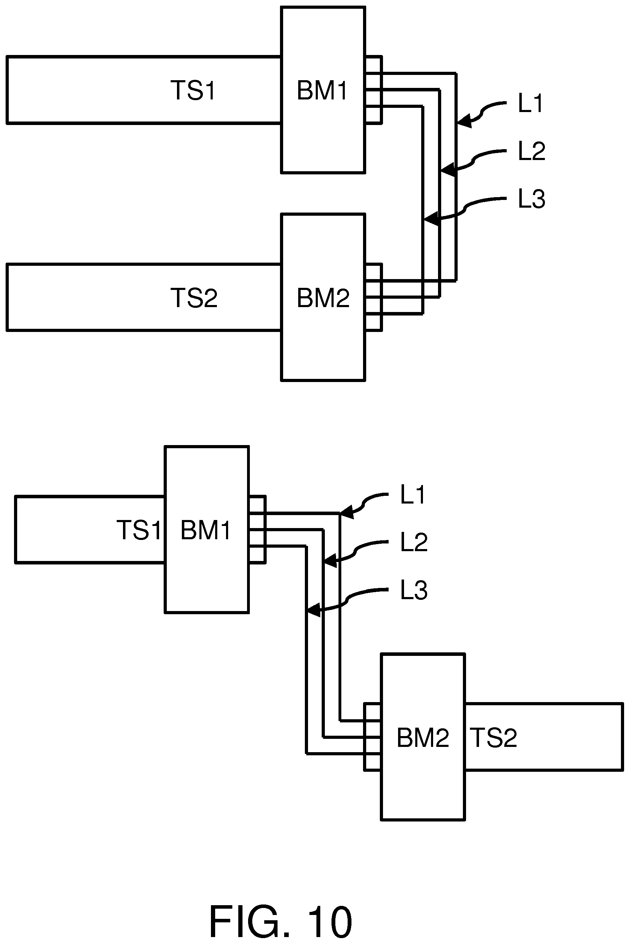

Das Bussystem kann sich auch über mehrere Tragschienen TS1, TS2 erstrecken wie in Figur 10 gezeigt. Dabei kann an ein erstes Busmodul BM1, welches sich auf einer ersten Tragschiene TS1 befindet, mittels eines Kabels mit geeigneten Steckverbindern an ein zweites Busmodul BM2, welches sich auf einer zweiten Tragschiene TS2 befindet, verbunden sein. Durch geeignete Ausgestaltung der Steckverbinder können sowohl Busmodule mit buchsenartige Aufnahmen B1, B2, B3 auf der einen Seite und Busmodule auf der anderen Seite mit entsprechenden stiftartigen Aufnahmen verbunden werden. Andererseits können auch gleichartige Steckverbinder vorgesehen sein, z.B. auf beiden Seiten buchsenartige Aufnahmen.

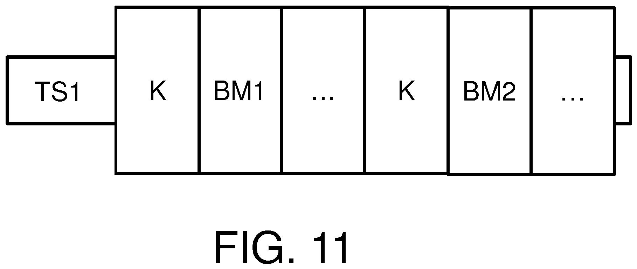

Weiterhin, sollte die Leistung eines Kopfmoduls K nicht ausreichend sein, könnte auch - wie in Figur 11 gezeigt - ein weiteres Kopfmodul K1 eingesetzt werden, dass die elektrische Leistung für weitere Module zur Verfügung stellt. Dabei bewirkt die Ausgestaltung des Bussystems das ein Fehler eines Überspannungsschutzmoduls M2, welches vermittels eines Busmoduls BM2 angeschlossen ist und welches sich logisch hinter dem zweiten Kopfmodul K1 befindet, von beiden Kopfmodulen K, K1 als Fehler angezeigt wird. Umgekehrt wird auch ein Fehler eines Überspannungsschutzmoduls M1, welches vermittels eines Busmoduls BM1 angeschlossen ist und welches sich logisch hinter der ersten Kopfstation K und vor dem zweiten Kopfmodul K1 befindet, von beiden Kopfmodulen K, K1 als Fehler angezeigt wird. D.h. der Bus kann so um eine Anzahl weiterer Module erweitert werden. Weiterhin ist es natürlich möglich auch mehr als zwei Kopfmodule einzusetzen.

Werden nun viele Überspannungsschutzeinrichtungen benötigt, kann die Zustandsabfrage über eine Fernabfrage realisiert werden, ohne einen zusätzlichen Verdrahtungsaufwand zu erfordern. Daher ist die Lösung kostengünstig und zudem vorteilhaft, da das Bussystem die Gefahr gelöster Verdrahtung minimiert.

Ein fehlerhaftes Überspannungsschutzmodul M1, M2, M3 kann zudem über den Signalbus seinen Zustand an die Kopfstation melden. Dabei kann der gemeldete Zustand zum Beispiel eine reine defekt oder nicht-defekt Anzeige des Überspannungsschutzmoduls beinhalten oder aber weitere Abstufungen enthalten, wie z.B. eine Anzeige einer Schädigung, die ein baldiges Auswechseln erfordert. Natürlich sind hier auch weitere Daten, wie z.B. die Anzahl der erfolgten Ableitungen und deren Dauer etc. übertragbar. Weiterhin kann auch eine eindeutige Kennung des Überspannungsschutzmoduls M1, M2, M3 vorgesehen sein, so dass das jeweilige Überspannungsschutzmodul als Absender der Anzeige bzw. der Daten erkennbar ist. Die Anzeige bzw. die Übermittlung der Daten zu einer Kopfstation K, K1 kann dabei zum einen über den Signalbus L3, zum anderen aber auch auf einer der Versorgungsleitungen L1, L2 (z.B. in 1-Wire Technik) als auch auf einer weiteren, nicht dargestellten Busleitung erfolgen.

**Bezugszeichenliste**

| | |
|---|---|
| Basiselement | ST1, ST2, ST3 |
| Überspannungsschutzmodul | M1, M2, M3 |
| erste Busverbindungseinrichtung | BK1, BK1' |
| zweite Busverbindungseinrichtung | BK2, BK2' |
| dritte Busverbindungseinrichtung | BK3, BK3' |
| elektronische Überwachungseinrichtung | UE1 |
| Kopfmodul | K, K1 |
| Widerstand | R1, R2, R3, R4 |
| Transistor | T1, T2 |
| Optische Signalisierungseinrichtung | LED |
| Akustische Signalisierungseinrichtung | SPK |
| Erstes Buspotential, Leitung | L1 |
| Zweites Buspotential, Leitung | L2 |
| Signalbus, Leitung | L3 |
| Tragschiene | TS1, TS2 |
| Busmodul | BM1, BM2 |
| Kontakte | B1, B2, B3 |
| Fernmeldungseinrichtung | OUT |

## Patentansprüche

1. Basiselement (ST1, ST2, ST3) zur Aufnahme eines Überspannungsschutzmoduls (M1, M2, M3) zur Verwendung in einem Bussystem, aufweisend
• eine erste Busverbindungseinrichtung (BK1) zur Kontaktierung mit einem ersten Buspotential (L1),
• eine zweite Busverbindungseinrichtung (BK2) zur Kontaktierung mit einem zweiten Buspotential (L2),
• eine dritte Busverbindungseinrichtung (BK3) zur Kontaktierung mit einem Signalbus (L3), wobei der Signalbus in einem ersten Zustand das Auftreten eines Fehlers und in einem zweiten Zustand das Nichtauftreten eines Fehlers anzeigt,
• wobei ein Fehler ein fehlendes bzw. fehlerhaft aufgenommenes bzw. fehlerbehaftetes Überspannungsschutzmodul (M1, M2, M3) anzeigt,
• wobei das erste und zweite Buspotential zur Versorgung von Einrichtungen auf dem Überspannungsschutzmodul (M1, M2, M3) verwendet werden soll,
• **dadurch gekennzeichnet, dass** das Basiselement weiterhin eine elektronische Überwachungseinrichtung (UE1) aufweist, wobei die elektronische Überwachungseinrichtung (UE1) erkennt, ob ein Überspannungsschutzmodul (M1, M2, M3) aufgenommenen ist, und wobei
• im Falle dass ein Überspannungsschutzmodul (M1, M2, M3) in das Basiselement (ST1, ST2, ST3) aufgenommenen ist, der zweite Zustand über den Signalbus signalisiert wird, und
• im Falle dass kein Überspannungsschutzmodul (M1, M2, M3) in das Basiselement (ST1, ST2, ST3) aufgenommenen ist oder aber das Überspannungsschutzmodul (M1, M2, M3) fehlerhaft aufgenommenen ist oder das Überspannungsschutzmodul (M1, M2, M3) fehlerbehaftet ist, zeigt der Signalbus den ersten Zustand.

2. Basiselement nach Anspruch 1, **dadurch gekennzeichnet, dass** die Basiselemente (ST1, ST2, ST3) auf eine Tragschiene (TS1, TS2) aufrastbar sind und das erste Buspotential (L1), das zweite Buspotential (L2) und der Signalbus (L3) in einer Vertiefung der Tragschiene (TS1, TS2) geführt werden.

3. Basiselement nach Anspruch 1 oder 2, **dadurch gekennzeichnet, dass** die elektronische Überwachungseinrichtung einen Halbleiterschalter aufweist.

4. Basiselement nach einem der vorhergehenden Ansprüche, **dadurch gekennzeichnet, dass** die elektronische Überwachungseinrichtung ein Öffner ist, wobei im Falle eines korrekt aufgenommenen Überspannungsschutzmoduls (M1) der Schalter geöffnet wird.

5. Basiselement nach einem der vorhergehenden Ansprüche, **dadurch gekennzeichnet, dass** die elektronische Überwachungseinrichtung einen Transistor aufweist.

6. Basiselement nach einem der vorhergehenden Ansprüche, **dadurch gekennzeichnet, dass** die elektronische Überwachungseinrichtung einen FET und / oder einen Bipolar Transistor aufweist.

7. Basiselement nach einem der vorhergehenden Ansprüche weiterhin aufweisend eine lokale Signalisierungseinrichtung zur optischen und / oder akustischen Anzeige, ob ein Überspannungsschutzmodul korrekt aufgenommen ist.

8. Basiselement nach einem der vorhergehenden Ansprüche, **dadurch gekennzeichnet, dass** die Buspotentiale mittels eines Systembusses zur Verfügung gestellt werden.

9. Modulares Bussystem mit
• einem oder mehreren Basiselementen (ST1, ST2, ST3) zur Aufnahme eines Überspannungsschutzmoduls (M1, M2, M3) gemäß einem der vorhergehenden Ansprüche und
• einem Kopfmodul (K1, K2) aufweisend:
▪ eine erste Busverbindungseinrichtung zur Kontaktierung mit einem ersten Buspotential,
▪ eine zweite Busverbindungseinrichtung zur Kontaktierung mit einem zweiten Buspotential,
▪ eine dritte Busverbindungseinrichtung zur Kontaktierung mit einem Signalbus, wobei der Signalbus in einem ersten Zustand das Auftreten eines Fehlers und in einem zweiten Zustand das Nichtauftreten eines Fehlers anzeigt,
▪ eine Signalisierungseinrichtung, welche anzeigt, ob auf dem Signalbus ein Fehler signalisiert wurde, wobei das Kopfmodul (K1, K2) auf eine Tragschiene (TS1, TS2) aufrastbar ist und das erste Buspotential (L1), das zweite Buspotential (L2) und der Signalbus (L3) in einer Vertiefung der Tragschiene (TS1, TS2) geführt wird.

10. Modulares Bussystem gemäß Anspruch 9, **dadurch gekennzeichnet, dass** das Kopfmodul (K1, K2) weiterhin eine Fernmeldungseinrichtung (OUT) aufweist, welche einen erkannten Fehler weitermelden kann.

11. Modulares Bussystem gemäß Anspruch 9 oder 10, **dadurch gekennzeichnet, dass** das Kopfmodul (K1, K2) über die erste und zweite Busverbindungseinrichtung ein erstes und ein zweites Buspotential zur Versorgung der Basiselemente zur Verfügung stellt

12. Modulares Bussystem nach einem der vorhergehenden Ansprüche 9 bis 11, **dadurch gekennzeichnet, dass** die Buspotentiale mittels eines Systembusses zur Verfügung gestellt werden.

13. Modulares Bussystem nach Anspruch 12, **dadurch gekennzeichnet, dass** der Systembus ein oder mehrere Busmodule (BM1, BM2) aufweist, wobei ein Busmodul auf eine Tragschiene (TS1, TS2) aufrastbar ist, und ein Busmodul (BM1, BM2) Busverbindungseinrichtungen (BK1, BK2, BK3) aufweist, die so gestaltet sind, dass sie die jeweiligen Buspotentiale (L1, L2, L3) einem aufgesteckten Kopfmodul (K1, K2) oder einen aufgesteckten Basiselement (ST1, ST2, ST3) zur Verfügung stellen können.

14. Modulares Bussystem nach einem der vorhergehenden Ansprüche 12 oder 13, **dadurch gekennzeichnet, dass** das Busmodul (BM1) zumindest auf einer Seite in der Ebene der Tragschiene (TS1, TS2) Kontakte (B1, B2, B3) zur Kontaktierung der Buspotentiale eines benachbarten Busmoduls (BM2) zur Verfügung stellt.

15. Modulares Bussystem nach einem der vorhergehenden Ansprüche 12 bis 14, **dadurch gekennzeichnet, dass** zumindest ein Teil der Busverbindungseinrichtungen (BK1, BK2, BK3) so gestaltet sind, dass sie eine oder mehrere buchsenartige Aufnahmen (B1, B2, B3) aufweisen, welche mit stiftartigen Aufnahmen in Verbindung gebracht werden können.

16. Modulares Bussystem nach einem der vorhergehenden Ansprüche 12 bis 15, **dadurch gekennzeichnet, dass** zumindest ein Teil der Busverbindungseinrichtungen (BK1, BK2, BK3) so gestaltet sind, dass sie eine oder mehrere stiftartige Aufnahmen aufweisen, welche mit buchsenartigen Aufnahmen (B1, B2, B3) in Verbindung gebracht werden können.

17. Modulares Bussystem nach einem der vorhergehenden Ansprüche 12 bis 16, **dadurch gekennzeichnet, dass** der Systembus über zwei oder mehr Kopfmodule (K, K1) verfügt.

18. Modulares Bussystem nach einem der vorhergehenden Ansprüche 12 bis 17, **dadurch gekennzeichnet, dass** der Systembus sich über zwei oder mehr Tragschienen (TS1, TS2) erstreckt.

## Claims

1. A base element (ST1, ST2, ST3) for receiving an overvoltage protective module (M1 M2, M3) for use in a bus system, having
• a first bus connection arrangement (BK1) for contacting a first bus potential (L1),
• a second bus connection arrangement (BK2) for contacting a second bus potential (L2),
• a third bus connection arrangement (BK3) for contacting a signal bus (L3), wherein the signal bus in a first state indicates the occurrence of a fault and in a second state indicates the non-occurrence of a fault,
• wherein a fault indicates a missing or incorrectly received or faulty overvoltage protective module (M1, M2, M3),
• wherein the first and second bus potential are to be used to supply arrangements on the overvoltage protective module (M1, M2, M3),
**characterised in that**
• the base element further comprises an electronic monitoring arrangement (UE1), wherein the electronic monitoring arrangement (UE1) identifies whether an overvoltage protective module (M1, M2, M3) is received,
and wherein:
• if an overvoltage protective module (M1, M2, M3) is received in the base element (ST1, ST2, ST3), the second state is signalled via the signal bus, and,
• if no overvoltage protective module (M1, M2, M3) is received in the base element (ST1, ST2, ST3) or if the overvoltage protective module (M1, M2, M3) is received incorrectly or if the overvoltage protective module (M1, M2, M3) is faulty, the first state is signalled via the signal bus.

2. The base element according to claim 1, **characterised in that** the base elements (ST1, ST2, ST3) can be clipped onto a mounting rail (TS1, TS2), and the first bus potential (L1), the second bus potential (L2), and the signal bus (L3) are guided in a recess in the mounting rail (TS1, TS2).

3. The base element according to claim 1 or 2, **characterised in that** the electronic monitoring arrangement has a semiconductor switch.

4. The base element according to any one of the preceding claims, **characterised in that** the electronic monitoring arrangement is an opener, wherein, in the event of a correctly received overvoltage protective module (M1), the switch is opened.

5. The base element according to any one of the preceding claims, **characterised in that** the electronic monitoring arrangement has a transistor.

6. The base element according to any one of the preceding claims, **characterised in that** the electronic monitoring arrangement has an FET and/or a bipolar transistor.

7. The base element according to any one of the preceding claims, further comprising a local signalling arrangement for providing an optical and/or acoustic display indicating whether an overvoltage protective module is correctly received.

8. The base element according to any one of the preceding claims, **characterised in that** the bus potentials are provided by means of a system bus.

9. A modular bus system comprising:
• one or more base elements (ST1, ST2, ST3) for receiving an overvoltage protective module (M1, M2, M3) according to any one of the preceding claims, and
• a head module (K1, K2) having:
▪ a first bus connection arrangement for contacting a first bus potential,
▪ a second bus connection arrangement for contacting a second bus potential,
▪ a third bus connection arrangement for contacting a signal bus, wherein the signal bus in a first state indicates the occurrence of a fault and in a second state indicates the non-occurrence of a fault, and
▪ a signalling arrangement which indicates whether a fault has been signalled over the signal bus, wherein the head module (K1, K2) can be clipped onto a mounting rail (TS1, TS2) and the first bus potential (L1), the second bus potential (L2) and the signal bus (L3) are guided in a recess in the mounting rail (TS1, TS2).

10. The modular bus system according to claim 9, **characterised in that** the head module (K1, K2) further comprises a remote notification arrangement (OUT), which can pass on notification of an identified fault.

11. The modular bus system according to claim 9 or 10, **characterised in that** the head module (K1, K2) provides via the first and second bus connection arrangement a first and a second bus potential for supplying the base elements.

12. The modular bus system according to any one of preceding claims 9 to 11, **characterised in that** the bus potentials are provided by means of a system bus.

13. The modular bus system according to claim 12, **characterised in that** the system bus has one or more bus modules (BM1, BM2), wherein a bus module can be clipped onto a mounting rail (TS1, TS2), and a bus module (BM1, BM2) has bus connection arrangements (BK1, BK2, BK3) that are designed such that they provide the respective bus potentials (L1, L2, L3) to a plugged-on head module (K1, K2) or to a plugged-on base element (ST1, ST2, ST3).

14. The modular bus system according to either one of preceding claims 12 or 13, **characterised in that** the bus module (BM1), at least on one side in the plane of the mounting rail (TS1, TS2), provides contacts (B1, B2, B3) for contacting the bus potentials of an adjacent bus module (BM2).

15. The modular bus system according to any one of preceding claims 12 to 14, **characterised in that** at least some of the bus connection arrangements (BK1, BK2, BK3) are designed such that they have one or more socket-like mounts (B1, B2, B3), which can be brought into connection with pin-like mounts.

16. The modular bus system according to any one of preceding claims 12 to 15, **characterised in that** at least some of the bus connection arrangements (BK1, BK2, BK3) are designed such that they have one or more pin-like mounts, which can be brought into connection with socket-like mounts (B1, B2, B3).

17. The modular bus system according to any one of preceding claims 12 to 16, **characterised in that** the system bus has two or more head modules (K, K1).

18. The modular bus system according to any one of preceding claims 12 to 17, **characterised in that** the system bus extends over two or more mounting rails (TS1, TS2).

## Revendications

1. Elément de base (ST1, ST2, ST3) pour la réception d'un module de protection contre les surtensions (M1, M2, M3) destiné à l'utilisation dans un système de bus, présentant
• un premier dispositif de connexion de bus (BK1) pour la mise en contact avec un premier potentiel de bus (L2),
• un deuxième dispositif de connexion de bus (BK2) pour la mise en contact avec un deuxième potentiel de bus (L2),
• un troisième dispositif de connexion de bus (BK3) pour la mise en contact avec un bus de signal (L3), où le bus de signal indique dans un premier état l'apparition d'une erreur et dans un deuxième état la non apparition d'une erreur,
• où une erreur indique un module de protection contre les surtensions (M1, M2, M3) enregistré manquant, respectivement erroné,
• où les premier et deuxième potentiels de bus doivent être employés pour l'alimentation des dispositifs sur le module de protection contre les surtensions (M1, M2, M3),
**caractérisé en ce que**
• l'élément de base présente en outre un dispositif de surveillance (UE1) électronique, où le dispositif de surveillance (UE1) électronique détecte si un module de protection contre les surtensions (M1, M2, M3) est enregistré,
et où
• dans le cas où un module de protection contre les surtensions (M1, M2, M3) est enregistré dans l'élément de base (ST1, ST2, ST3), le deuxième état est signalé par l'intermédiaire du bus de signal, et
• dans le cas où aucun module de protection contre les surtensions (M1, M2, M3) n'est enregistré dans l'élément de base (ST1, ST2, ST3) ou, alors, que le module de protection contre les surtensions (M1, M2, M3) est enregistré de manière erronée ou que le module de protection contre les surtensions (M1, M2, M3) est erroné, le bus de signal indique le premier état.

2. Elément de base selon la revendication 1, **caractérisé en ce que** les éléments de base (ST1, ST2, ST3) peuvent être verrouillés sur un rail support (TS1, TS2) et le premier potentiel de bus (L1), le deuxième potentiel de bus (L2) et le bus de signal (L3) sont guidés dans une cavité du rail support (TS1, TS2).

3. Elément de base selon la revendication 1 ou 2, **caractérisé en ce que** le dispositif de surveillance électronique présente un commutateur de semi-conducteur.

4. Elément de base selon l'une des revendications précédentes, **caractérisé en ce que** le dispositif de surveillance électronique est un dispositif d'ouverture, où, dans le cas d'un module de protection contre les surtensions (M1) correctement enregistré, le commutateur est ouvert.

5. Elément de base selon l'une des revendications précédentes, **caractérisé en ce que** le dispositif de surveillance électronique présente un transistor.

6. Elément de base selon l'une des revendications précédentes, **caractérisé en ce que** le dispositif de surveillance électronique présente un transistor à effet de champ FET et/ou un transistor bipolaire.

7. Elément de base selon l'une des revendications précédentes, présentant en outre un dispositif de signalisation local pour l'indication optique et/ou acoustique si un module de protection contre les surtensions est enregistré correctement.

8. Elément de base selon l'une des revendications précédentes, **caractérisé en ce que** les potentiels de bus sont mis à disposition au moyen d'un bus de système.

9. Système de bus modulaire doté
• d'un ou de plusieurs éléments de base (ST1, ST2, ST3) pour l'enregistrement d'un module de protection contre les surtensions (M1, M2, M3) selon l'une des revendications précédentes et
• d'un module de tête (K1, K2) présentant :
▪ un premier dispositif de connexion de bus pour la mise en contact avec un premier potentiel de bus,
▪ un deuxième dispositif de connexion de bus pour la mise en contact avec un deuxième potentiel de bus,
▪ un troisième dispositif de connexion de bus pour la mise en contact avec un bus de signal, où le bus de signal indique dans un premier état l'apparition d'une erreur et dans un deuxième état la non apparition d'une erreur,
▪ un dispositif de signalisation, lequel indique si une erreur a été signalée sur le bus de signal, où le module de tête (K1, K2) peut être verrouillé sur un rail support (TS1, TS2) et le premier potentiel de bus (L1), le deuxième potentiel de bus (L2) et le bus de signal (L3) sont guidés dans une cavité du rail support (TS1, TS2).

10. Système de bus modulaire selon la revendication 9, **caractérisé en ce que** le module de tête (K1, K2) présente en outre un dispositif de transmission à distance (OUT), lequel peut transmettre une erreur détectée.

11. Système de bus modulaire selon la revendication 9 ou 10, **caractérisé en ce que** le module de tête (K1, K2) met à disposition un premier et un deuxième potentiel de bus pour l'alimentation des éléments de base par l'intermédiaire des premier et deuxième dispositifs de connexion de bus.

12. Système de bus modulaire selon l'une des revendications précédentes 9 à 11, **caractérisé en ce que** les potentiels de bus sont mis à disposition au moyen d'un système de bus.

13. Système de bus modulaire selon la revendication 12, **caractérisé en ce que** le bus de système présente un ou plusieurs modules de bus (BM1, BM2), où un module de bus peut être verrouillé sur un rail support (TS1, TS2) et un module de bus (BM1, BM2) présente des dispositifs de connexion de bus (BK1, BK2, BK3) qui sont conçus de telle manière qu'ils peuvent mettre à disposition les potentiels de bus (L1, L2, L3) respectifs à un module de tête (K1, K2) branché ou à un élément de base (St1, ST2, ST3) branché.

14. Système de bus modulaire selon l'une des revendications précédentes 12 ou 13, **caractérisé en ce que** le module de bus (BM1) met à disposition des contacts (B1, B2, B3) pour la mise en contact des potentiels de bus d'un module de bus (BM2) voisin au moins sur un côté dans le plan du rail support (TS1, TS2).

15. Système de bus modulaire selon l'une des revendications précédentes 12 à 14, **caractérisé en ce qu'**au moins une partie des dispositifs de connexion de bus (BK1, BK2, BK3) est conçue de telle manière qu'elle peut présenter un ou plusieurs réceptacles de type boîtes (B1, B2, B3), lesquels peuvent être mis en connexion avec des réceptacles en forme de tiges.

16. Système de bus modulaire selon l'une des revendications précédentes 12 à 15, **caractérisé en ce qu'**au moins une partie des dispositifs de connexion de bus (BK1, BK2, BK3) est conçue de telle manière qu'ils présentent un ou plusieurs réceptacles en forme de tiges, lesquels peuvent être mis en connexion avec des réceptacles en forme de boîtes (B1, B2, B3).

17. Système de bus modulaire selon l'une des revendications précédentes 12 à 16, **caractérisé en ce que** le bus de système dispose de deux ou plus modules de tête (K, K1).

18. Système de bus modulaire selon l'une des revendications précédentes 12 à 17, **caractérisé en ce que** le système de bus s'étend sur deux ou plus de rails supports (TS1, TS2).
